# EUROPÄISCHE PATENTANMELDUNG

(11) **EP 2 219 217 A2**
(43) Veröffentlichungstag der Anmeldung: **18.08.2010**
(21) Anmeldenummer: 09016025.0
(22) Anmeldetag: 24.12.2009
(51) Int. Cl.: H01L 23/24

(54) **Halbleitermodul**

(30) Priorität: 16.02.2009 DE 102009000884
(71) Anmelder: SEMIKRON Elektronik GmbH & Co. KG, 90431 Nürnberg (DE)
(72) Erfinder: Braml, Heiko, Dr., 91346 Wiesenttal (DE); Fey, Tobias, Dr., 91058 Erlangen (DE); Göbl, Christian, 90441 Nürnberg (DE); Sagebaum, Ulrich, 90408 Nürnberg (DE)

(57) **Zusammenfassung**

Die Erfindung betrifft ein Halbleitermodul, insbesondere Leistungshalbleitermodul, bei dem ein mit einem Substrat (1) verbundenes halbleitendes Bauelement (2) mit einer elektrisch isolierenden Vergussmasse (4) umgossen ist. Zur Verbesserung der Wärmeableitung von den halbleitenden Bauelementen (2) wird erfindungsgemäß vorgeschlagen, dass die Vergussmasse (4) eine aus einem präkeramischen Polymer gebildete Matrix aufweist.

## Beschreibung

Die Erfindung betrifft ein Halbleitermodul nach dem Oberbegriff des Anspruchs 1.

Ein solches Halbleitermodul ist beispielsweise aus der DE 10 2004 021 927 A1 bekannt. Dabei sind mit einem Substrat verbundene halbleitende Bauelemente mit einer elektrisch isolierenden Vergussmasse umgossen. Damit werden die halbleitenden Bauelemente und deren Anschlüsse vor einem Kontakt mit Staub oder Feuchtigkeit geschützt.

Bekannte Vergussmassen, welche beispielsweise auf der Basis von Silikon hergestellt werden, weisen eine relativ niedrige Wärmeleitfähigkeit λ von 0,2 bis 0,3 W/mK auf. Eine beim Betrieb von den halbleitenden Bauelementen erzeugte Wärme wird relativ schlecht abgeführt. Das beschränkt die Leistung des Halbleitermoduls.

Aufgabe der Erfindung ist es, die Nachteile nach dem Stand der Technik zu beseitigen. Es soll insbesondere ein Halbleitermodul mit verbesserter Wärmeableitung angegeben werden. Nach einem weiteren Ziel der Erfindung soll die Leistung des Halbleitermoduls erhöht werden.

Diese Aufgabe wird durch die Merkmale des Anspruchs 1 gelöst. Zweckmäßige Ausgestaltungen der Erfindung ergeben sich aus den Merkmalen der Ansprüche 2 bis 9.

Nach Maßgabe der Erfindung ist vorgesehen, dass die Vergussmasse eine aus einem präkeramischen Polymer gebildete Matrix aufweist. Eine solche Vergussmasse ist elektrisch isolierend. Sie weist eine hervorragende Wärmeleitfähigkeit λ auf. Ein weiterer Vorteil der vorgeschlagenen Vergussmasse ist deren hohe Temperaturbeständigkeit. Sie hält Betriebstemperaturen von bis zu 300°C stand.

Im Sinne der vorliegenden Erfindung wird unter dem Begriff "Substrat" ein z. B. in Form einer Platte vorliegendes elektrisch isolierendes Material verstanden, welches mit Leiterbahnen versehen ist. Darauf kann zumindest ein halbleitendes Bauelement beispielsweise mittels eines Lots, eines Klebstoffs oder dgl. montiert sein.

Unter dem Begriff "umgossen" wird im Sinne der vorliegenden Erfindung verstanden, dass ein mit dem Substrat zuvor verbundenes halbleitendes Bauelement nachfolgend mit der Vergussmasse übergossen wird. Infolgedessen überdeckt die Vergussmasse das halbleitende Bauelement, d. h. umgreift dessen seitliche Wände sowie dessen Oberseite. Eine dem Substrat zugewandte Unterseite des halbleitenden Bauelements ist dagegen nicht oder nur teilweise mit der Vergussmasse in Kontakt.

Unter dem Begriff "präkeramisches Polymer" wird ein Polymer verstanden, welches z. B. mit zunehmender Temperatur zunächst in einen gelartigen und nachfolgend in einen duroplastischen Zustand übergeht. Im duroplastischen Zustand weist ein präkeramisches Polymer in der Regel eine Temperaturbeständigkeit von bis zu 300°C auf. Bei einer weiteren Temperaturerhöhung können aus präkeramischen Polymeren keramische Werkstoffe hergestellt werden. Zu präkeramischen Polymeren gehören beispielsweise Polysilane, Polycarbosilane und Polyorganosilazane.

Nach einer vorteilhaften Ausgestaltung ist vorgesehen, dass das präkeramische Polymer mit einem Füllgrad von bis zu 80 Vol.% mit einem Füllstoff gefüllt ist. Damit können die Wärmeleitfähigkeit und die Viskosität des präkeramischen Polymers erhöht werden.

Zweckmäßigerweise handelt es sich bei dem Füllstoff um ein aus einem keramischen Material gebildetes Pulver mit einer mittleren Korngröße im Bereich von 0,5 bis 500 µm. Das vorgeschlagene keramische Material ist weitgehend inert. Dessen Zusatz führt nicht zu unerwünschten chemischen Reaktionen mit dem präkeramischen Polymer. Die vorgeschlagene mittlere Korngröße ermöglicht ein Vergießen der Vergussmasse mit herkömmlichen Vorrichtungen.

Die Wärmeleitfähigkeit λ des keramischen Materials ist zweckmäßigerweise bei Raumtemperatur größer als 10 W/mK, vorzugsweise größer als 20 W/mK. Je nach Füllgrad gelingt es damit, die Wärmeleitfähigkeit des mit dem keramischen Material gefüllten präkeramischen Polymers auf Werte oberhalb 2 W/mK zu steigern. Damit eignet sich die vorgeschlagene Vergussmasse insbesondere zur Herstellung eines im Betrieb eine relativ große Wärme freisetzenden Leistungshalbleitermoduls.

Das keramische Material ist zweckmäßigerweise aus der folgenden Gruppe ausgewählt: BN, SiC, Si₃N₄, AlN, Steatit, Cordierit. Die vorgeschlagenen keramischen Materialien zeichnen sich durch eine hohe Wärmeleitfähigkeit aus.

Weiterhin hat es sich als zweckmäßig erwiesen, dass das präkeramische Polymer aus der folgenden Gruppe ausgewählt ist: Polysiloxan, Polysilazan, Polycarbosilan.

Üblicherweise ist beim Halbleitermodul ein das halbleitende Bauelement zumindest abschnittsweise umgebendes Gehäuse vorgesehen. Ein solches Gehäuse ist in der Regel aus einem Polymer hergestellt. Das Gehäuse wird üblicherweise mit dem Substrat verbunden, nachdem darauf das halbleitende Bauelement montiert worden ist.

Nach einer vorteilhaften Ausgestaltung der Erfindung ist vorgesehen, dass ein Zwischenraum zwischen dem halbleitenden Bauelement und einem das halbleitende Bauelement umgebenden Gehäuse zumindest teilweise mit der Vergussmasse gefüllt ist. Damit bildet die Vergussmasse eine wärmeleitende Brücke zwischen dem halbleitenden Bauelement und dem Gehäuse.

Die Vergussmasse wird üblicherweise in einem niedrigviskosen Zustand vergossen. Damit können Kapillarkräfte ausgenutzt und ein besonders guter thermischer Kontakt zwischen der Vergussmasse und dem halbleitenden Bauelement gewährleistet werden. Nachfolgend kann das präkeramische Polymer beispielsweise durch Temperaturerhöhung, Strahlungsbehandlung oder dgl. bis zu einem vorgegebenen Grad vernetzt werden. Das präkeramische Polymer kann dann also insbesondere in gelartiger oder duroplastischer Form vorliegen.

Nach einer besonders vorteilhaften alternativen Ausgestaltung ermöglicht die Verwendung der erfindungsgemäßen Vergussmasse auch die Weglassung des zur Herstellung von Halbleitermodulen üblicherweise verwendeten Gehäuses. Ein das halbleitende Bauelement umgebendes Gehäuse kann in einstückiger Ausbildung mit der Vergussmasse aus dem in duroplastischer Form vorliegenden präkeramischen Polymer gebildet sein. D. h. das mit dem Substrat verbundene halbleitende Bauelement kann z. B. mit einer Form umgeben werden, in welche anschließend die Vergussmasse eingegossen und dann in die duroplastische Form überführt wird. In diesem Fall bildet also die Vergussmasse das Gehäuse. Bei der Form kann es sich auch um eine "verlorene Form" handeln, beispielsweise um einen auf das Substrat aufgesetzten und das halbleitende Bauelement umgebenden Rahmen. Der Rahmen weist in diesem Fall zweckmäßigerweise eine aus dem präkeramischen Polymer gebildete Matrix auf. Dabei liegt die präkeramische Matrix in duroplastischer Form vor. Zweckmäßigerweise weist der Rahmen dieselbe Materialzusammensetzung wie die Vergussmasse auf. Die vorgeschlagene verlorene Form kann vor dem Einfüllen der Vergussmasse auch mit dem Substrat, beispielsweise wiederum mittels eines präkeramischen Polymers, verklebt werden. Damit wird eine besonders gute Abdichtung zwischen dem Rahmen und dem Substrat erreicht.

Nachfolgend werden Ausführungsbeispiele der Erfindung anhand der Figuren näher erläutert. Es zeigen:
- Fig. 1: eine schematische Querschnittsansicht durch ein erstes Halbleitermodul und
- Fig. 2: eine schematische Querschnittsansicht durch ein zweites Halbleitermodul.

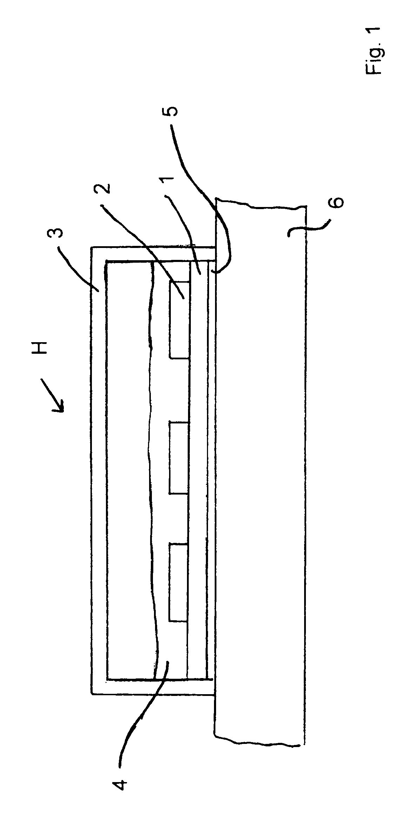

Fig. 1 zeigt eine schematische Querschnittsansicht durch ein erstes Halbleitermodul. Auf einem Substrat 1, beispielsweise einem DCB-Substrat, sind mehrere halbleitenden Bauelemente 2, beispielsweise Leistungshalbleiter, wie Dioden, Thyristoren, IGBTs, MOSFETs oder Sensorbauelemente, mittels einer Lötverbindung montiert. Die halbleitenden Bauelemente 2 sind abschnittsweise von einem Gehäuse 3 umgeben. Das Gehäuse 3 kann - wie in Fig. 1 gezeigt - das Substrat 1 randlich umgreifen. Es kann aber auch auf das Substrat 1 aufgesetzt sein. Mit dem Bezugszeichen 4 ist eine Vergussmasse bezeichnet, welche die halbleitenden Bauelemente 2 und das Substrat 1 zumindest abschnittsweise überdeckt und randlich an eine umlaufende Gehäusewand anschließt. Das so beschaffene Halbleitermodul H ist unter Zwischenschaltung einer Wärmeleitpaste 5 auf einen Kühlkörper 6 montiert.

Die Vergussmasse 4 ist hier aus einem präkeramischen Polymer, beispielsweise Polysiloxan, gebildet, welches zu etwa 40 bis 50 Vol.% mit einem Füllstoff gefüllt ist. Bei dem Füllstoff kann es sich um ein SiC-Pulver mit einer mittleren Korngröße beispielsweise im Bereich von 1 bis 5 µm handeln. Der Füllstoff ist in das in gelartiger oder duroplastischer Form vorliegende präkeramische Polymer eingebettet. Die so gebildete Vergussmasse weist eine hervorragende Wärmeleitfähigkeit von mehr als 10 W/mK auf.

Zur Herstellung des in Fig. 1 gezeigten Halbleitermoduls kann beispielsweise ein herkömmliches Gehäuse 3 zunächst über das Substrat 1 gestülpt werden, so dass das Substrat 1 randlich an die umlaufende Gehäusewand anschließt. Anschließend kann durch einen (hier nicht gezeigten) Durchbruch im Gehäuse 3 die Vergussmasse 4 eingefüllt werden. Dabei liegt das präkeramische Polymer in einer niedrig viskosen fließfähigen Form vor. In einem nächsten Schritt wird die Vergussmasse 4 sodann beispielsweise durch Temperaturerhöhung vernetzt und in einen gelartigen oder duroplastischen Zustand versetzt. Damit wird das Gehäuse 3 fest mit dem Substrat 1 verklebt. Die Vergussmasse 4 bildet eine hervorragende Wärmebrücke von den halbleitenden Bauelementen 2 zum Gehäuse 3 und von da in die Umgebung. - Eine besonders gute Anbindung der Vergussmasse 4 an das Gehäuse 3 wird erreicht, wenn auch das Gehäuse 3 aus einem in duroplastischer Form vorliegenden präkeramischen Polymer gebildet ist. In diesem Fall weist auch das Gehäuse 3 eine hervorragende Wärmeleitfähigkeit λ auf.

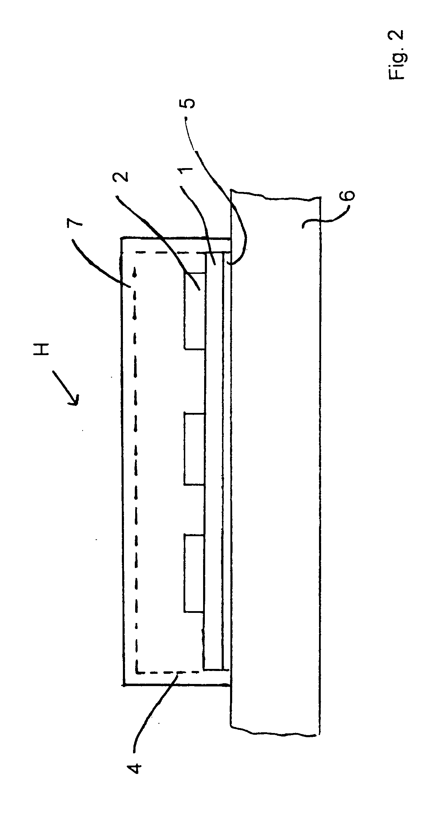

Fig. 2 zeigt eine schematische Querschnittsansicht durch ein zweites Halbleitermodul H. Hier ist das in Fig. 1 gezeigte Gehäuse 3 weggelassen. Die Vergussmasse 4 ersetzt hier das Gehäuse. Sie ist nach Art eines Gehäuses geformt und überdeckt die halbleitenden Bauelemente 2, zumindest abschnittsweise eine den halbleitenden Bauelementen 2 zugewandte Oberseite des Substrats 1 sowie vorteilhafterweise einen umlaufenden Rand des Substrats 1.

Die Herstellung eines in einem Stück der Vergussmasse 4 gebildeten Gehäuses kann beispielsweise unter Verwendung einer "verlorenen Form" erfolgen. Dazu kann zunächst eine mit der unterbrochenen Linie kenntlich gemachte Gehäuseform 7 auf das Substrat 1 gesetzt oder auch über das Substrat 1 gestülpt werden. Die Gehäuseform 7 ist dabei zweckmäßigerweise aus demselben Material wie die Vergussmasse hergestellt, wobei das präkeramische Polymer hier in duroplastischer Form vorliegt. Anschließend wird durch einen in der Gehäuseform 7 vorgesehenen Durchbruch (hier nicht gezeigt) die Vergussmasse eingegossen und nachfolgend beispielsweise durch eine Temperaturerhöhung ebenfalls in den duroplastischen Zustand überführt, so dass die Vergussmasse 4 und die Gehäuseform 7 ein einstückiges Gehäuse bilden.

### Bezugszeichenliste

- 1: Substrat
- 2: halbleitendes Bauelement
- 3: Gehäuse
- 4: Vergussmasse
- 5: Wärmeleitpaste
- 6: Kühlkörper
- 7: Gehäuseform

- H: Halbleitermodul

## Patentansprüche

1. Halbleitermodul, insbesondere Leistungshalbleitermodul, bei dem ein mit einem Substrat (1) verbundenes halbleitendes Bauelement (2) mit einer elektrisch isolierenden Vergussmasse (4) umgossen ist,
**dadurch gekennzeichnet, dass**
die Vergussmasse (4) eine aus einem präkeramischen Polymer gebildete Matrix aufweist.

2. Halbleitermodul nach Anspruch 1, wobei das präkeramische Polymer mit einem Füllgrad von bis zu 80 Vol.% mit einem Füllstoff gefüllt ist.

3. Halbleitermodul nach einem der vorhergehenden Ansprüche, wobei der Füllstoff ein aus einem keramischen Material gebildetes Pulver mit einer mittleren Korngröße im Bereich von 0,5 bis 500 µm ist.

4. Halbleitermodul nach einem der vorhergehenden Ansprüche, wobei die Wärmeleitfähigkeit λ des keramischen Materials bei Raumtemperatur größer als 10 W/mK, vorzugsweise größer als 20 W/mK, ist.

5. Halbleitermodul nach einem der vorhergehenden Ansprüche, wobei das keramische Material aus der folgenden Gruppe ausgewählt ist: BN, SiC, Si₃N₄, AlN, Steatit, Cordierit.

6. Halbleitermodul nach einem der vorhergehenden Ansprüche, wobei das präkeramische Polymer aus der folgenden Gruppe ausgewählt ist: Polysiloxan, Polysilazan, Polycarbosilan.

7. Halbleitermodul nach einem der vorhergehenden Ansprüche, wobei ein Zwischenraum zwischen dem halbleitenden Bauelement (2) und einem das halbleitende Bauelement (2) zumindest abschnittsweise umgebenden Gehäuse (3) zumindest teilweise mit Vergussmasse (4) gefüllt ist.

8. Halbleitermodul nach einem der vorhergehenden Ansprüche, wobei das präkeramische Polymer in gelartiger oder duroplastischer Form vorliegt.

9. Halbleitermodul nach einem der Ansprüche 1 bis 6, wobei ein das halbleitende Bauelement (2) umgebendes Gehäuse (3) in einstückiger Ausbildung mit der Vergussmasse (4) aus dem in duroplastischen Form vorliegenden präkeramischen Polymer gebildet ist.
